# FASCICULE DE BREVET EUROPEEN

(11) **EP 0 810 665 B1**
(45) Date de publication et mention de la délivrance du brevet: **01.08.2012**
(21) Numéro de dépôt: 97410054.7
(22) Date de dépôt: 28.05.1997
(51) Int. Cl.: H01L 27/112

(54) **Matrice de mémoire ROM compacte**
Kompakte ROM-Speichermatrix
Compact ROM memory matrix

(30) Priorité: 31.05.1996 FR 9606949
(43) Date de publication de la demande: 03.12.1997
(73) Titulaire: DOLPHIN INTEGRATION, F-38240 Meylan (FR)
(72) Inventeur: Zangara, Louis, 38180 Seyssins (FR)
(74) Mandataire: de Beaumont, Michel

(56) Documents cités:
- EP-A- 0 151 476
- PATENT ABSTRACTS OF JAPAN vol. 014, no. 391 (E-0968), 23 Août 1990 & JP 02 144965 A (HITACHI LTD), 4 Juin 1990,

## Description

La présente invention concerne une matrice mémoire ou plan mémoire ROM.

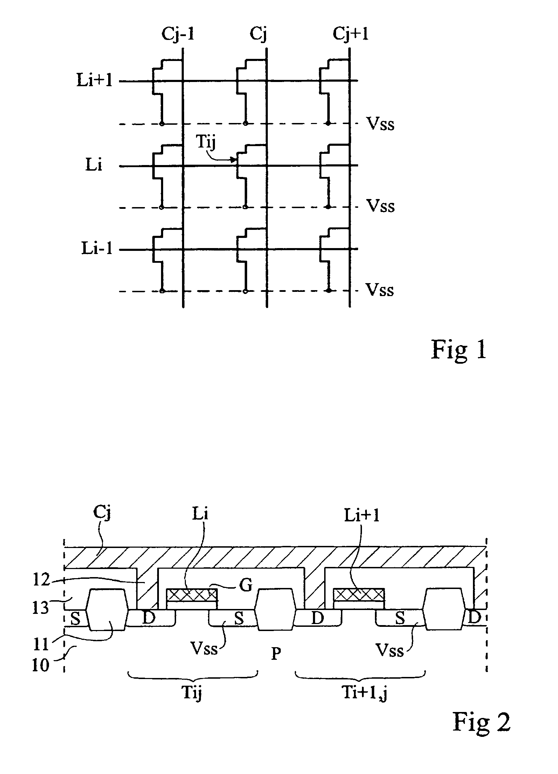

La figure 1 représente de façon générale la structure d'une matrice mémoire ROM. Celle-ci est constituée d'un ensemble de rangées ou lignes de mot Li croisant des colonnes ou lignes de bit Cj. A chaque croisement d'une rangée Li et d'une colonne Cj est disposé un transistor Tij dont la grille est connectée à une ligne Li, le drain à une colonne Cj et la source à un potentiel de référence Vss, par exemple la masse.

La matrice mémoire est programmée à la fabrication de sorte qu'il existe ou non un transistor Tij à chaque point de croisement. Pour des raisons de simplicité de fabrication et d'équilibrage des charges, on dispose généralement un transistor Tij à chaque point de croisement et on inhibe les transistors situés aux points de croisement que l'on souhaite inactifs, par exemple en inhibant leur grille ou en ne réalisant pas leur connexion de drain.

Cette structure matricielle est associée à divers circuits de décodage de rangées ou lignes de mot et de colonnes ou lignes de bit, de précharge, d'amplification, de multiplexage, etc. Ces divers circuits, connus et ne faisant pas en eux-mêmes l'objet de la présente invention, ne seront pas décrits ici.

La figure 2 représente de façon très schématique une vue en coupe selon une colonne d'une structure élémentaire mettant en oeuvre le plan mémoire de la figure 1. Chaque transistor Tij est formé dans un substrat semiconducteur 10 d'un premier type de conductivité faiblement dopé, et est séparé de ses voisins par une région d'oxyde épais 11. La grille G de ce transistor MOS correspond à une portion d'une ligne conductrice Li, par exemple en silicium polycristallin, recouvrant toutes les grilles des transistors MOS d'une même rangée et s'étendant, entre les transistors, au-dessus des régions d'oxyde épais. Les sources S de tous les transistors d'une même rangée correspondent à une partie d'une rangée diffusée continue reliée au potentiel Vss (il n'y a pas d'oxyde épais entre les sources de transistors adjacents d'une même rangée). Tous les drains D des transistors d'une colonne sont reliés à une même métallisation de colonne Cj par l'intermédiaire de vias 12.

Le schéma de la figure 2 est extrêmement simplifié et, dans des réalisations pratiques, diverses modifications sont apportées. Par exemple, les drains et sources sont de type LDD, un prédopage d'ajustement de seuil est réalisé sous les grilles, le silicium polycristallin de grille est revêtu d'un siliciure métallique, plusieurs niveaux de silicium polycristallin existent, plusieurs niveaux de métallisation existent...

De toute manière, les phases successives de fabrication d'un circuit intégré incorporant un plan mémoire ROM comprennent séquentiellement les principales étapes suivantes :
- réalisation de préimplantation,
- réalisation d'oxyde épais,
- réalisation d'un premier niveau de silicium polycristallin
- réalisation de zones diffusées,
- réalisation de divers niveaux de métallisation.

De façon générale, dans l'industrie des semiconducteurs, on sépare nettement les opérations techniques réalisées dans le silicium (premier stade ou Front End) des opérations relatives à la formation de métallisations et de vias (deuxième stade ou Back End). Ces deux types d'opérations sont réalisés dans des secteurs différents d'une même usine, voire dans des usines distinctes.

D'un point de vue pratique, il est intéressant de reporter les étapes de programmation d'un plan mémoire (détermination des transistors actifs et inactifs) au deuxième stade de fabrication. En effet, on peut alors préfabriquer un composant intermédiaire comprenant toutes les diffusions dans le silicium, aussi bien au niveau du plan mémoire qu'au niveau des autres composants, par exemple un processeur, réalisés dans le même circuit intégré, et stocker ce composant intermédiaire pour programmer le plan mémoire ROM par les métallisations lors de l'arrivée d'une commande d'un client, ce qui permet d'atteindre des délais de fourniture beaucoup plus rapides.

Comme on l'a indiqué précédemment, il existe diverses techniques pour inhiber des points de croisement choisis.

Une première famille de techniques consiste à inhiber les grilles des transistors. Ceci peut se faire en laissant subsister un oxyde épais à l'emplacement où serait normalement formé l'oxyde fin de grille. Cette technique présente l'inconvénient que la programmation du plan mémoire doit se faire au premier stade de fabrication. Une autre technique consiste à réaliser des implantations sous la grille pour surdoper le substrat et rendre ainsi l'action de la grille inopérante. Cette autre technique présente l'inconvénient d'être complexe et de rajouter une étape de fabrication par rapport aux procédés usuels, et aussi de devoir être réalisée au premier stade de fabrication.

Toutefois, ces techniques de programmation par la grille présentent l'avantage de permettre d'augmenter considérablement la densité d'intégration par rapport à la structure de base illustrée en figure 1.

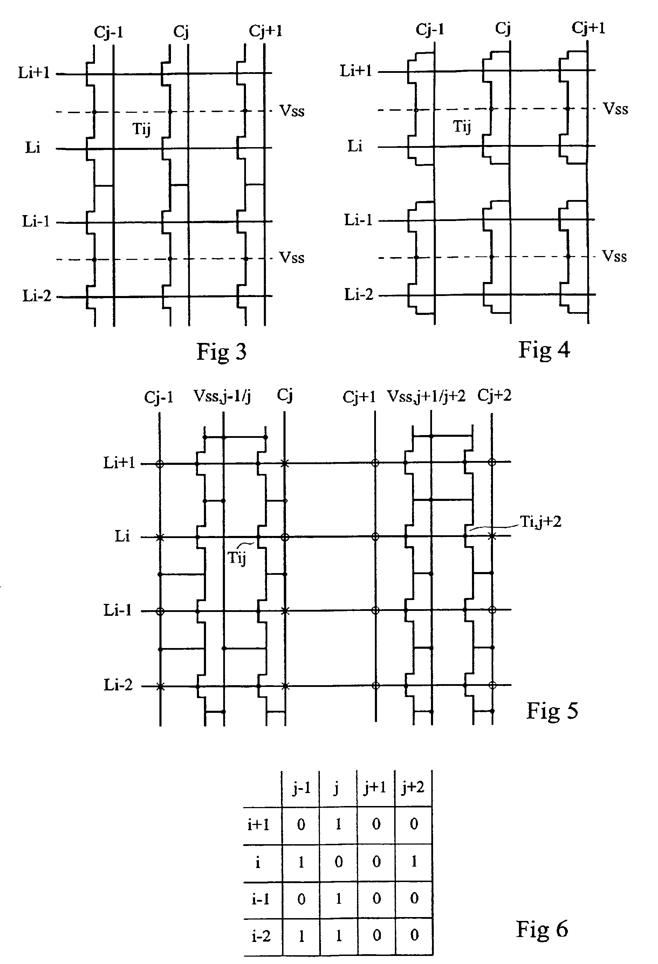

Ceci est illustré en figure 3 (voir aussi EPO151476, figure 3) qui représente un plan mémoire réalisé de sorte que chaque couple de lignes de mot partage une même rangée de référence Vss (dans l'exemple, entre les rangées Li-2 et Li-1 et entre les rangées Li et Li+1). Ceci signifie que chaque couple de transistors adjacents d'une même rangée partage une même source. De même, les drains de deux transistors adjacents, par exemple entre les lignes Li-1 et Li sont communs. L'avantage de cette structure est que l'on supprime les rangées d'oxyde épais entre rangées de transistors et que l'on divise par 2 le nombre de drains et de sources. Il est clair qu'il en résulte une réduction de taille très importante du plan mémoire par rapport au schéma élémentaire de la figure 1.

Une deuxième famille de techniques consiste à réaliser ou non les connexions entre une métallisation de colonne et des drains individuels. Pour cela, en se reportant à la figure 2, on notera qu'il suffit de supprimer certains des vias 12. La programmation peut donc se faire par un masque de gravure de contacts (qui est éventuellement réalisé entre deux couches de métallisation supérieures et non pas sous une couche de métallisation inférieure comme cela est représenté dans la figure). Ce type de techniques présente l'avantage que la programmation de la mémoire ROM peut être réalisée au deuxième stade de fabrication.

Toutefois, ces techniques présentent l'inconvénient que l'on ne peut plus, comme dans le schéma de la figure 3, prévoir une structure dans laquelle des transistors adjacents ont un drain commun. On est alors amené à utiliser des configurations de plan mémoire du type de celle de la figure 4 dans lesquelles des transistors adjacents ont bien une source commune mais des drains séparés, c'est-à-dire qu'une portion d'oxyde épais existera entre les rangées Li-1 et Li dans la représentation de la figure 4. Ainsi, par rapport à la structure élémentaire de la figure 1, on réduit la dimension en supprimant une diffusion de source sur deux et l'oxyde épais intermédiaire entre ces sources mais l'on conserve toutes les diffusions de drain et les oxydes épais séparant ces régions de drain.

Ainsi, dans l'état actuel de la technique, on se trouve en pratique devant un choix qui conduit à privilégier, ou bien, le caractère compact d'un plan mémoire en choisissant une technique de programmation par les grilles au détriment de la commodité de fabrication, ou bien la commodité de fabrication en choisissant une technique de programmation par les drains au détriment de la compacité.

Ainsi, un objet de la présente invention est de prévoir un plan mémoire ROM programmable par des métallisations et présentant une forte compacité.

Un autre objet de la présente invention est de prévoir un tel plan mémoire particulièrement simple à fabriquer et à programmer.

Un autre objet de la présente invention est de prévoir un tel plan mémoire à faibles capacités parasites et qui se prête donc à une lecture rapide.

Pour atteindre ces objets, la présente invention telle que revendiquée dans la revendication 1, prévoit un plan mémoire matriciel à rangées et colonnes sensiblement orthogonales comprenant un substrat semiconducteur d'un premier type de conductivité, des colonnes d'oxyde épais séparant des colonnes actives, des rangées de grille d'un premier matériau conducteur, un isolant de grille étant interposé aux emplacements où ces rangées recouvrent les colonnes actives, des îlots dopés du deuxième type de conductivité délimités par les colonnes d'oxyde épais et les rangées de grille, des premières colonnes conductrices au pas des colonnes actives, constituant des lignes de bit, des deuxièmes colonnes conductrices à un pas double de celui des premières colonnes, constituant des lignes de référence, et des moyens de liaison électrique entre chaque îlot et la première colonne conductrice correspondante ou la deuxième colonne conductrice adjacente.

Selon un mode de réalisation de la présente invention, un transistor actif, constitué de deux îlots situés de part et d'autre d'une zone de grille, est réalisé en connectant le premier îlot à une première colonne et le deuxième îlot à une deuxième colonne.

Selon un mode de réalisation de la présente invention, un transistor inactif, constitué de deux îlots situés de part et d'autre d'une zone de grille, est réalisé en connectant ses deux îlots à une première colonne ou à une deuxième colonne.

Selon un mode de réalisation de la présente invention, chacun des îlots est relié à des plots situés à un niveau de métallisation donné.

Selon un mode de réalisation de la présente invention, la programmation est réalisée par le choix de la configuration du niveau de métallisation contenant les plots et aussi les lignes de référence et de vias reliant certains des plots à un niveau de métallisation supérieur.

Selon un mode de réalisation de la présente invention, pour une programmation donnée, les connexions des îlots de chaque colonne active sont choisies pour que le nombre de connexions à la ligne de bit soit inférieur au nombre de connexions à la ligne de référence.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, décrite précédemment, représente un schéma de base d'un plan mémoire ROM ;
la figure 2, décrite précédemment, représente une vue en coupe selon une colonne d'une portion d'une structure simplifiée mettant en oeuvre un plan mémoire ;
les figures 3 et 4, décrites précédemment, représentent de façon schématique des plans mémoire ;
la figure 5 représente un plan mémoire selon la présente invention ;
la figure 6 représente une table de programmation du plan mémoire de la figure 5 ;
la figure 7A représente une vue en coupe selon une colonne d'une portion d'une structure mettant en oeuvre un plan mémoire selon la présente invention ;
la figure 7B représente une vue de dessus d'une portion d'un plan mémoire selon la présente invention ; et
la figure 7C représente une vue en coupe selon une rangée, et en perspective, d'une portion d'un plan mémoire selon la présente invention avant réalisation des métallisations.

Comme cela est usuel dans le domaine de la représentation des composants semiconducteurs, les diverses vues de structures ne sont pas représentées à l'échelle.

Comme le représente la figure 5, un plan mémoire selon la présente invention comprend des colonnes de transistors dans lesquelles les sources et drains de deux transistors adjacents sont confondus, c'est-à-dire que pour deux points de croisement adjacents d'une même colonne, on n'utilise que deux régions diffusées, ce qui donne à la structure, dans le sens des colonnes, la même compacité que dans le cas du mode de réalisation de la figure 3. Ces régions diffusées sont sous forme d'îlots. Contrairement au cas des structures des figures 1, 3 et 4 (dans lesquelles les liaisons au potentiel de référence Vss étaient réalisées par des rangées diffusées dont des portions correspondaient à des sources de transistors), il n'y a pas de continuité entre des ensembles de régions diffusées d'une même rangée.

Comme précédemment, toutes les grilles d'une même rangée de points de croisement, par exemple la rangée Li, sont constituées de portions d'une même ligne conductrice, par exemple une ligne de silicium polycristallin.

Dans le sens des colonnes, à chaque colonne d'îlots diffusés est associée une métallisation en colonne (Cj-1, Cj, Cj+1, Cj+2) formant une ligne de bit et à chaque paire de lignes de bits est associée une métallisation en colonne ou ligne de référence. Ainsi, on trouve une ligne de référence Vss_{j-1/j} entre les lignes de bit Cj-1 et Cj et une ligne de référence Vss_{j+i/j+2} entre les lignes de bit Cj+1 et Cj+2.

Pour rendre un transistor Tij actif, on relie l'une de ses bornes (drain ou source) à la colonne Cj correspondante et l'autre de ses bornes (source ou drain) à la colonne Vss_{j-1/j} correspondante. Pour rendre le transistor inactif, on relie ses deux bornes ou bien à la colonne Cj ou bien à la colonne Vss_{j-1/j}.

En examinant la figure 5, on notera que la portion de plan mémoire représentée correspond à la table de programmation représentée en figure 6. Par exemple, le transistor Tij dont les deux bornes sont reliées à la colonne Cj est inactif et le transistor Ti,j+2 dont une borne est relié à sa ligne de bit et l'autre à sa ligne de référence est actif.

Ainsi, le plan mémoire selon la présente invention, illustré en figure 5, présente la même compacité dans la direction des colonnes que le plan mémoire de la figure 3 et donc une compacité nettement supérieure à celle du plan mémoire de la figure 4.

Dans la direction des rangées, le plan mémoire selon la présente invention a apparemment une compacité plus faible que celle du plan mémoire des figures 3 et 4, en raison de la présence des lignes de référence. Toutefois, la différence est en fait négligeable. En effet, si l'on considère par exemple huit colonnes successives, la présente invention prévoit de rajouter aux huit lignes de bit quatre colonnes métallisées constituant des lignes de référence. Mais, en pratique, même dans une structure du type de celle de la figure 3, la conductivité des rangées diffusées de liaison au potentiel Vss est faible. Pour l'augmenter, on est amené à reprendre périodiquement des contacts métalliques sur ces rangées diffusées pour établir des connexions avec des colonnes métalliques qui sont prévues par exemple une fois toutes les huit colonnes. Ainsi, selon la présente invention, on ne rajoute en fait que trois colonnes métalliques par groupe de huit lignes de bits par rapport à la structure de la figure 3. En outre, la prévision de ces colonnes de référence n'amène à une augmentation de dimension notable dans la direction des rangées par rapport au cas où elles n'existent pas. En effet, dans la direction des rangées, au moins les drains de deux transistors adjacents sont séparés par une région d'oxyde épais et cette région d'oxyde épais a sensiblement la largeur nécessaire au positionnement d'une ligne métallique. L'augmentation de dimension est donc nulle ou très faible.

En utilisant une filière classique pour laquelle la limite de définition d'un motif est de 0, 5 µm, une structure selon la présente invention présente une augmentation de surface de seulement quelques pour-cent, par exemple 5 à 8 %, par rapport à une structure du type de celle de la figure 3. Par contre, la structure de la figure 4 entraînait une augmentation de surface de l'ordre de 25 % par rapport à celle de la figure 3.

Ainsi, la présente invention, tout en conservant sensiblement les avantages de compacité de la structure de la figure 3 présente en outre les avantages de possibilité de programmation au deuxième stade de fabrication de la structure de la figure 4.

Un autre avantage de la présente invention par rapport aux structures antérieures résulte de l'existence d'une ligne de référence isolée par paires de lignes de bit, cette ligne de référence étant distincte pour chaque paire de lignes de bit. Par contre, dans les structures de l'art antérieur, comme on l'a indiqué précédemment, toutes les lignes de référence au potentiel Vss sont interconnectées. L'isolement mutuel des lignes de référence obtenu avec la structure selon l'invention entraîne la possibilité d'adresser simultanément seulement un nombre choisi de lignes de référence. Ainsi quand on adresse seulement un nombre limité de lignes de bit, on adressera seulement les lignes de référence correspondantes. Il en résulte une réduction des capacités parasites et de la consommation de la mémoire.

Un autre avantage de la présente invention résulte du fait qu'aucun îlot diffusé n'est spécifiquement alloué à une connexion à la borne Vss. Ainsi, pour un transistor inactif, les deux îlots adjacents correspondant sont reliés ou bien à Vss (ligne de référence) ou bien à Vdd (ligne de bit). Le choix des liaisons pour un point de croisement donné dépend du choix effectué pour le point de croisement précédent de la même colonne. Toutefois, ce choix peut être inversé pour l'ensemble des transistors d'une colonne. En conséquence, il est possible pour chaque colonne active d'optimiser les connexions pour connecter majoritairement les paires de bornes des transistors inactifs au potentiel Vss. Ainsi, la charge sur les lignes de bit Cj, connectées à un potentiel haut, Vdd, en phase de lecture, peut être réduite et ainsi les capacités parasites peuvent être réduites, d'où il résulte une rapidité de lecture accrue. Par exemple, dans l'exemple de la figure 5, on notera que pour les points de croisement de la ligne j, il y a plus de liaisons à la ligne de bit Cj qu'à la ligne de référence Vss_{j-1/j} ; s'il s'agissait d'une matrice complète, on pourrait sans inconvénient inverser ces liaisons (il en est de même pour la ligne j+2).

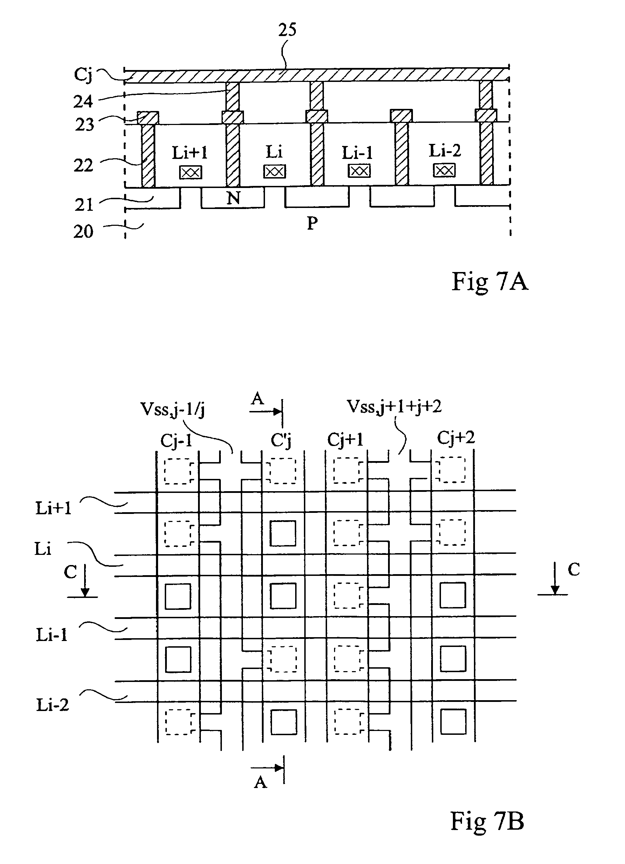

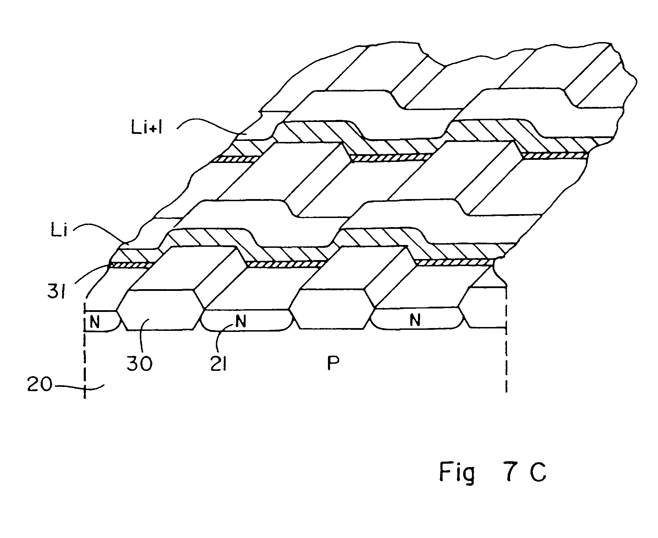

Les figures 7A, 7B et 7C représentent un exemple de réalisation de la présente invention. Il sera clair pour l'homme de l'art que le mode de réalisation décrit ne constitue qu'un exemple et que de nombreuses variantes de réalisation sont possibles, notamment en ce qui concerne les matériaux utilisés et les niveaux de métallisation.

La figure 7A représente une vue en coupe d'une portion d'un mode de réalisation d'un plan mémoire selon la présente invention prise selon une colonne active. Dans un substrat semiconducteur 20 d'un premier type de conductivité, par exemple P, sont formés des îlots 21 dopés du type de conductivité opposé, ici le type N. Les îlots 21 sont séparés par des régions de substrat recouvertes d'un isolant de grille et d'une portion d'une rangée de silicium polycristallin, Li+1, Li, Li-1, Li-2. Chaque îlot 21 est relié par un via 22 à un plot 23 d'un premier niveau de métallisation. Les plots 23 sont reliés, ou bien, par un via 24 à un niveau de métallisation supérieur 25 correspondant à une colonne Cj, ou bien, en dehors du plan de la figure, à une métallisation de même niveau constituant une colonne de référence, par exemple Vss_{j-1/j}. C'est donc au niveau de la gravure des plots 23 et des vias 24 que l'on confère à la structure la programmation choisie.

Bien entendu, il est à la portée de l'homme de l'art de réaliser diverse variantes de connexions d'un îlot vers une ligne de bit ou une ligne de référence. Dans des technologies utilisant plusieurs niveaux de métallisation, par exemple 4 à 7, la programmation pourra être obtenue par le choix de configurations de métallisations et de vias de niveau supérieur.

La figure 7B représente une vue de dessus de la structure où l'on peut voir les lignes Cj-1, Vss_{j-1/j}, Cj, Cj+1, Vss_{j+1/j+2} et Cj+2 ainsi que les rangées Li+1, Li, Li-1, Li-2. Au-dessus de chaque îlot diffusé (non visible), on a représenté par un carré en pointillés un contact qui assure une liaison vers une ligne de référence Vss et par un carré en trait plein un contact vers une ligne de bit Cj par l'intermédiaire d'un via 24.

La figure 7C représente une vue en coupe selon la ligne CC de la figure 7B (selon une rangée), et en perspective, d'une structure selon la présente invention à la fin du premier stade de fabrication.

Comme on le voit dans la figure 7C, les colonnes actives sont séparées les unes des autres par des colonnes d'oxyde épais 30 (première étape de fabrication). A intervalle régulier, des rangées de silicium polycristallin Li, Li+1, s'étendent, d'une part, au-dessus des régions d'oxyde épais 30, d'autre part, au-dessus de zones d'oxyde mince 31 formées sur les parties actives (deuxième étape de fabrication). Ensuite, la structure est soumise à une implantation de type N pour former des îlots 21 du deuxième type de conductivité dans les colonnes actives entre les régions de grille (troisième étape de fabrication). Après cela, la structure de la figure 7C est revêtue d'une couche isolante (non représentée) qui est de préférence planarisée. A ce stade, la structure peut être stockée dans l'attente de la réalisation des vias 22, des plots 23 et des vias 24 de la figure 7A. On pourra aussi réaliser les premiers niveaux de métallisation et de vias jusqu'au niveau de vias et de métallisation déterminant la programmation d'une mémoire selon la présente invention.

## Revendications

1. Plan mémoire matriciel à rangées et colonnes sensiblement orthogonales comprenant :
un substrat semiconducteur (20) d'un premier type de conductivité,
des colonnes (30) d'oxyde épais séparant des colonnes actives,
des rangées de grille (Li) conductrice, un isolant de grille (31) étant interposé aux emplacements où ces rangées recouvrent les colonnes actives,
des îlots (21) du deuxième type de conductivité délimités par les colonnes d'oxyde épais et les rangées de grille,
des premières colonnes conductrices (Cj) au pas des colonnes actives, constituant des lignes de bit,
des deuxièmes colonnes conductrices (Vss) à un pas double de celui des premières colonnes, constituant des lignes de référence, et
des moyens de liaison électrique entre chaque îlot et la première colonne conductrice correspondante ou la deuxième colonne conductrice adjacente.

2. Plan mémoire selon la revendication 1, **caractérisé en ce qu'**un transistor actif, constitué de deux îlots situés de part et d'autre d'une zone de grille, est réalisé en connectant le premier îlot à une première colonne et le deuxième îlot à une deuxième colonne.

3. Plan mémoire selon la revendication 1, **caractérisé en ce qu'**un transistor inactif, constitué de deux îlots situés de part et d'autre d'une zone de grille, est réalisé en connectant ses deux îlots à une première colonne ou à une deuxième colonne.

4. Plan mémoire selon la revendication 1, **caractérisé en ce que** chacun des îlots est relié à des plots situés à un niveau de métallisation donné.

5. Plan mémoire selon la revendication 4, **caractérisé en ce que** la programmation est réalisée par le choix de la configuration dudit niveau de métallisation contenant les plots et aussi lesdites lignes de référence et de vias reliant certains desdits plots à un niveau de métallisation supérieur.

6. Plan mémoire selon la revendication 1, **caractérisé en ce que**, pour une programmation donnée, les connexions des îlots de chaque colonne active sont choisies pour que le nombre de connexions à la ligne de bit soit inférieur au nombre de connexions à la ligne de référence.

## Claims

1. A memory array with substantially orthogonal rows and columns including:
a semiconductor substrate (20) of a first conductivity type,
thick oxide columns (30) separating active columns,
conductive gate rows (Li), a gate insulator (31) being interposed at the locations where these rows cover the active columns,
islands (21) of the second conductivity type limited by the thick oxide columns and the gate rows,
first conductive columns (Cj) at the pitch of the active columns, constituting bit lines,
second conductive columns (Vss) at a pitch which is twice that of the first columns, constituting reference lines, and
connection means between each island and the first corresponding conductive column or the second adjacent conductive column.

2. A memory array according to claim 1, wherein an active transistor, comprised of two islands located on either side of a gate area, is implemented by connecting the first island to a first column and the second island to a second column.

3. A memory array according to claim 1, wherein an inactive transistor, comprised of two islands located on either side of a gate area, is implemented by connecting its two islands to a first column or to a second column.

4. A memory array according to claim 1, wherein each of the islands is connected to pads located at a given metallization level.

5. A memory array according to claim 4, wherein the programming is performed by selecting the configuration of the metallization level including the pads and also the reference and via lines connecting some of the pads to a higher metallization level.

6. A memory array according to claim 1, wherein for a given programming, the connections of the islands of each active column are selected so that the number of connections to the bit line is lower than the number of connections to the reference line.

## Patentansprüche

1. Eine Speicheranordnung mit im Wesentlichen orthogonalen Zeilen und Spalten, die Folgendes aufweist:
ein Halbleitersubstrat (20) eines ersten Leitfähigkeitstyps,
dicke Oxidspalten (30), die aktive Spalten trennen,
leitende Gate-Zeilen (Li), wobei ein Gate-Isolator (31) an den Stellen eingesetzt ist, wo diese Zeilen die aktiven Spalten überdecken,
Inseln (21) eines zweiten Leitfähigkeitstyps, begrenzt durch die dicken Oxidspalten und die Gate-Zeilen,
erste leitende Spalten (Cj) an dem Steigung (Pitch) der aktiven Spalten,
Bitzeilen bildend,
zweite leitende Spalten (Vss) an einer Steigung (Pitch), die das Doppelte der ersten Spalten ist und zwar Referenzzeilen bildend, und
Verbindungsmittel zwischen jeder Insel und der ersten entsprechenden leitenden Spalte oder der zweiten benachbarten leitenden Spalte.

2. Speicheranordnung nach Anspruch 1, wobei ein aktiver Transistor zwei Inseln auf jeder Seite der Gate-Fläche aufweisend vorgesehen ist und implementiert ist durch Verbinden der ersten Insel mit einer ersten Spalte und der zweiten Insel mit einer zweiten Spalte.

3. Speicheranordnung nach Anspruch 1, wobei ein inaktiver Transistor bestehend aus zwei Inseln, angeordnet auf jeder Seite der Gate-Fläche, implementiert wird durch Verbinden seiner zwei Inseln mit einer ersten Spalte oder einer zweiten Spalte.

4. Speicheranordnung nach Anspruch 1, wobei jede der Inseln mit Anschlüssen (Pads) verbunden ist, die auf einem gegebenen Metallisierungsniveau angeordnet sind.

5. Speicheranordnung nach Anspruch 4, wobei die Programmierung ausgeführt wird durch Auswahl der Konfiguration des Metallisierungspegels einschließlich der Anschlüsse (Pads) und auch der Referenz- und Via-Zeilen, die einige der Anschlüsse mit einem höheren Metallisierungsniveau verbinden.

6. Speicheranordnung nach Anspruch 1, wobei für eine gegebene Programmierung die Verbindungen der Inseln jeder aktiven Spalte derart ausgewählt sind, dass die Anzahl der Verbindungen mit der Bitzeile niedriger ist als die Anzahl der Verbindungen mit der Referenzzeile.
